# EUROPÄISCHE PATENTANMELDUNG

(11) **EP 4 686 075 A1**
(43) Veröffentlichungstag der Anmeldung: **28.01.2026**
(21) Anmeldenummer: 25190038.7
(22) Anmeldetag: 16.07.2025
(51) Int. Cl.: H02M 7/5387, H02M 7/00, H02M 1/44, H02G 5/00, H05K 7/14

(54) **LEISTUNGSELEKTRONISCHE ANORDNUNG VON STROMSCHIENEN, LEISTUNGSELEKTRONISCHE KOMPONENTE SOWIE LEISTUNGSELEKTRONISCHE VORRICHTUNG**

(30) Priorität: 26.07.2024 DE 102024207077
(71) Anmelder: VOLKSWAGEN AG, 38440 Wolfsburg (DE)
(72) Erfinder: Söhnle, Benjamin, 38440 Wolfsburg (DE); Sommer, Christian, 38440 Wolfsburg (DE); Wehry, Eduard, 38440 Wolfsburg (DE); Pries, Marcel, 38440 Wolfsburg (DE)

(57) **Zusammenfassung**

Die Erfindung betrifft eine leistungselektronische Anordnung (100) von Stromschienen (10, 20), umfassend mindestens eine erste Stromschiene (10) eines ersten elektrischen Potentials (+) und mindestens eine weitere Stromschiene (20) eines weiteren elektrischen Potentials (-), wobei die Stromschienen (10, 20) zueinander beabstandet sind, wobei in mindestens einem Abschnitt (50) der Anordnung (100) die mindestens eine erste Stromschiene (10) parallel zu der mindestens einen weiteren Stromschiene (20) orientiert ist, wobei sowohl die mindestens eine erste Stromschiene (10) als auch die mindestens eine weitere Stromschiene (20) in dem mindestens einen Abschnitt (50) gekrümmt (11, 21) ausgebildet sind,
sowie eine leistungselektronische Komponente (210, 220) und eine leistungselektronische Vorrichtung (200).

## Beschreibung

Die Erfindung betrifft eine leistungselektronische Anordnung von Stromschienen, eine leistungselektronische Komponente sowie eine leistungselektronische Vorrichtung.

In leistungselektronischen Schaltungen - die beispielsweise in Wechselrichter für Elektrofahrzeuge Anwendung finden - ist eine hohe Schaltgeschwindigkeit von darin verbauten Leistungshalbleitern wie z.B. MOSFETs gewünscht. Es ist bekannt, dass die Schaltgeschwindigkeit vor allem durch eine niedrigere Induktivität der in der leistungselektronischen Schaltung verwendeten Bauteile verbessert werden kann. Insbesondere kann die Schaltgeschwindigkeit durch ein elektrisches Verbinden von Bauteilen mit einer niedrigen sogenannten äquivalenten Serieninduktivität (kurz ESL) verbessert werden.

Aus der DE 10 2020 109 500 A1 ist ein Verfahren zum Verbinden von wenigstens zwei elektronischen Bauteilen bekannt, die jeweils einen Bauteilkörper und wenigstens eine von dem Bauteilkörper abstehende Kontaktlasche aufweisen.

Aus der DE 10 2022 120 170 A1 ist eine leistungselektronische Vorrichtung mit Stromschienen zur Verwendung in einer Kommutierungszelle eines Inverters eines elektrisch angetriebenen Kraftfahrzeugs bekannt.

Es stellt sich das technische Problem, eine leistungselektronische Anordnung von Stromschienen, eine leistungselektronische Komponente sowie eine leistungselektronische Vorrichtung zu schaffen, welche eine niedrige Induktivität, insbesondere eine niedrige Serieninduktivität, aufweisen.

Die Lösung des technischen Problems ergibt sich durch die Gegenstände mit den Merkmalen der unabhängigen Ansprüche. Weitere vorteilhafte Ausgestaltungen der Erfindung ergeben sich aus den Unteransprüchen.

Vorgeschlagen wird eine leistungselektronische Anordnung von Stromschienen, umfassend mindestens eine erste Stromschiene eines ersten elektrischen Potentials und mindestens eine weitere Stromschiene eines weiteren elektrischen Potentials, wobei die Stromschienen zueinander beabstandet sind, wobei in mindestens einem Abschnitt der Anordnung die mindestens eine erste Stromschiene parallel zu der mindestens einen weiteren Stromschiene orientiert ist, wobei sowohl die mindestens eine erste Stromschiene als auch die mindestens eine weitere Stromschiene in dem mindestens einen Abschnitt gekrümmt ausgebildet sind.

Weiter vorgeschlagen wird eine leistungselektronische Komponente, umfassend mindestens eine leistungselektronische Anordnung nach einer in dieser Offenbarung beschriebenen Ausführungsform.

Weiter vorgeschlagen wird eine leistungselektronische Vorrichtung, umfassend mindestens eine erste Komponente und mindestens eine weitere Komponente, wobei die mindestens eine erste Komponente mit der mindestens einen weiteren Komponente mittels mindestens einer leistungselektronischen Anordnung nach einer in dieser Offenbarung beschriebenen Ausführungsform elektrisch verbunden ist.

Selbstverständlich treffen die im Folgenden für die leistungselektronische Anordnung genannten technischen Effekte und Vorteile ebenso auf die leistungselektronische Komponente und die leistungselektronische Vorrichtung zu.

Aufgrund der parallelen Orientierung der Stromschienen in dem mindestens einen Abschnitt können die Stromschienen sehr nah zueinander angeordnet werden, ohne sich zu berühren. Dieser geringe Abstand der Stromschienen zueinander minimiert die Induktivität der Anordnung, da der geringe Abstand zwischen den Stromscheinen im Betrieb zu einer geringeren magnetischen Flussdichte führt und somit die Gesamtkopplung der im Betrieb erzeugten magnetischen Felder reduziert wird, was wiederum die Induktivität verringert. Ferner können die Stromschienen aufgrund ihrer Krümmung in dem mindestens einen Abschnitt Wegstrecken in zumindest zwei Raumrichtung überbrücken, z.B. in vertikaler und horizontaler Raumrichtung, ohne den genannten Vorteil hinsichtlich der Induktivität aufzugeben. Hierdurch können mittels der vorgeschlagenen Anordnung zwei leistungselektronische Komponenten, wie z.B. ein Zwischenkreiskondensator und eine Leistungsbox, elektrisch miteinander verbunden werden, wobei aufgrund der niedrigen Induktivität der Anordnung folgerichtig eine Serieninduktivität der elektrischen Verbindung ebenfalls niedriger ist. Die niedrige Serieninduktivität der elektrischen Verbindung kann wiederum eine Schaltgeschwindigkeit von in den Komponenten verwendeten Leistungshalbleitern - wie z.B. MOSFETs - verbessern. Die erhöhte Schaltgeschwindigkeit wiederum kann als Sekundäreffekt die Reichweite eines Elektrofahrzeugs erhöhen, da elektrische Verluste beim Schalten der Leistungshalbleiter reduziert sind.

Mit anderen Worten: Die Stromschienen sind in dem mindestens einen Abschnitt im Wesentlichen als Parallelflächen ausgebildet, die leicht zueinander beabstandet sind, um einen Kurzschluss zu vermeiden. Insbesondere überdecken sich die Stromschienen in dem mindestens einen Abschnitt. Gleichzeitig sind die Stromschienen in dem mindestens einen Abschnitt gekrümmt, um mittels der Stromschienen Wegstrecken in zumindest zwei Raumrichtungen überbrücken zu können.

Die mindestens eine erste Stromschiene kann im Betrieb ein positives bzw. hohes elektrisches Potential aufweisen. Dieses kann als erstes elektrisches Potential bezeichnet werden. Die mindestens eine erste Stromschiene kann einen Pluspol einer ersten leistungselektronischen Komponente (wie z.B. einen Zwischenkreiskondensator) mit einem Pluspol einer weiteren leistungselektronischen Komponente (wie z.B. eine Leistungsbox) elektrisch verbinden. Die mindestens eine erste Stromschiene kann zumindest teilweise als flächiges Blech ausgebildet sein. Die mindestens eine erste Stromschiene kann z.B. Kupfer aufweisen oder aus Kupfer hergestellt sein. Die mindestens eine erste Stromschiene kann z.B. eine Dicke von mindestens 0,5 mm aufweisen.

Die mindestens eine weitere Stromschiene kann im Betrieb ein negatives (bzw. ein gegenüber dem Potential der ersten Stromschiene niedrigeres) elektrisches Potential aufweisen. Dieses kann auch als weiteres elektrisches Potential bezeichnet werden. Die mindestens eine weitere Stromschiene kann einen Minuspol einer ersten leistungselektronischen Komponente (wie z.B. einen Zwischenkreiskondensator) mit einem Minuspol einer weiteren leistungselektronischen Komponente (wie z.B. eine Leistungsbox) elektrisch verbinden. Eine umgekehrte Konstellation der elektrischen Potentiale zwischen der ersten Stromschiene und der weiteren Stromschiene ist selbstverständlich ebenfalls möglich. Die mindestens eine weitere Stromschiene kann zumindest teilweise als flächiges Blech ausgebildet sein. Die mindestens eine weitere Stromschiene kann z.B. Kupfer aufweisen oder aus Kupfer hergestellt sein. Die mindestens eine weitere Stromschiene kann z.B. eine Dicke von mindestens 0,5 mm aufweisen.

Der mindestens eine Abschnitt der Anordnung ist ein Teil der Anordnung, in welchem eine Orientierung der Stromschienen zueinander als parallel bezeichnet werden kann. Der mindestens eine Abschnitt der Anordnung kann z.B. der Teil der Anordnung sein, in welchem ein Abstand der Stromschienen zueinander um nicht mehr als einen vorbekannten Wert variiert. Innerhalb dieser Variation können die Stromschienen als parallel zueinander orientiert bezeichnet werden. Die Variation des Abstands kann z.B. auf Fertigungstoleranzen zurückzuführen sein. Der vorbekannte Wert der Variation des Abstands kann z.B. 0,5 mm betragen.

In einer Ausführungsform beträgt ein Abstand zwischen der mindestens einen ersten Stromschiene und der mindestens einen weiteren Stromschiene in dem mindestens einen Abschnitt weniger als 1 mm. Da ein geringer Abstand der Stromschienen zueinander maßgeblich für eine geringe Induktivität ist, kann mit einer derart ausgebildeten Anordnung die Induktivität deutlich reduziert werden. Der Abstand kann z.B. als direkte Weglänge von einem Oberflächenpunkt der ersten Stromschiene entlang einer Flächennormalen der ersten Stromschiene zu einem Oberflächenpunkt der weiteren Stromschiene bestimmt werden.

In einer Ausführungsform ist in dem mindestens einen Abschnitt eine nichtleitende Schicht zwischen der mindestens einen ersten Stromschiene und der mindestens einen weiteren Stromschiene angeordnet. Auf diese Weise können Kurzschlüsse zwischen den beiden Stromschienen unterbunden werden. Die nichtleitende Schicht kann z.B. zumindest eine der Stromschienen ummanteln. Die nichtleitende Schicht kann z.B. als Folie ausgebildet sein. Dies ist in der Herstellung kostengünstig. Die nichtleitende Schicht kann alternativ oder kumulativ z.B. als eine Lackierung bzw. Beschichtung zumindest einer Stromschiene ausgebildet sein. Die nichtleitende Schicht kann einen Kunststoff, insbesondere ein Kunstharz, wie z.B. Epoxidharz aufweisen oder daraus hergestellt sein. Die nichtleitende Schicht kann insbesondere einen Zwischenraum zwischen der mindestens einen ersten Stromschiene und der mindestens einen weiteren Stromschiene in dem mindestens einen Abschnitt zumindest teilweise oder vollständig ausfüllen. Insbesondere ist die nichtleitende Schicht nichtmagnetisch ausgebildet. Dies reduziert die Induktivität der Anordnung weiter, da auf diese Weise eine Permeabilität zwischen den Stromschienen verringert werden kann.

In einer Ausführungsform umfasst zumindest eine der Stromschienen mindestens eine Kontaktlasche, wobei die mindestens eine Kontaktlasche eine Federwirkung aufweist. Etwaige Montagetoleranzen und mechanische oder thermische Spannungen - wie sie z.B. zwischen den Komponenten einer leistungselektronischen Vorrichtung auftreten - können mittels der Anordnung ausgeglichen werden, wobei die Montagetoleranzen oder Spannungen über die Federwirkung der Kontaktlasche kompensiert werden können. Die Kontaktlasche dient insbesondere zur Kontaktierung einer leistungselektronischen Komponente. Die mindestens eine Kontaktlasche kann z.B. als ein Endstück einer Stromschiene ausgebildet sein. Insbesondere kann die mindestens eine erste Stromschiene mindestens eine erste Kontaktlasche aufweisen und die mindestens eine weitere Stromschiene kann mindestens eine weitere Kontaktlasche aufweisen, wobei eine mehrere oder alle Kontaktlasche(n) eine Federwirkung aufweisen kann/können.

In einer Ausführungsform ist die mindestens eine Kontaktlasche gekrümmt ausgebildet. Die Federwirkung kann hierbei durch die Krümmung der Kontaktlasche erzielt werden. Ferner kann eine Orientierung, insbesondere ein Winkel, der Kontaktlasche durch die Krümmung angepasst werden. Die Kontaktlasche kann einfach oder mehrfach gekrümmt sein, d.h. eine oder mehrere Krümmungen aufweisen. Die Kontaktlasche kann z.B. durch Biegen eines Endstücks einer Stromschiene gekrümmt werden. Die Krümmung erleichtert zudem eine Positionierung der Kontaktlaschen über z.B. einer Kontaktfläche einer Komponente einer leistungselektronischen Vorrichtung.

In einer Ausführungsform weisen die mindestens eine erste Stromschiene und die mindestens eine weitere Stromschiene jeweils mindestens ein Kontaktsegment auf, wobei die Kontaktsegmente in einer gemeinsamen Ebene angeordnet sind. Auf diese Weise können die Kontaktsegmente z.B. eine Komponente einer leistungselektronischen Vorrichtung in der gemeinsamen Ebene kontaktieren. Dies erleichtert insbesondere ein Fügeverfahren zwischen den Kontaktsegmenten der Stromschienen und z.B. zugehörigen Kontaktflächen der Komponente, da beim Fügen keine Höhenunterschiede zwischen den jeweiligen Fügestellen ausgeglichen werden müssen. Beispielsweise kann das Fügen der Kontaktsegmente der Stromschienen mit den zugehörigen Kontaktflächen der Komponente erfolgen, indem ein Schweißgerät entlang einer Raumrichtung in der gemeinsamen Ebene verfährt und auf diese Weise die jeweiligen Kontaktsegmente mit den zugehörigen Kontaktflächen verschweißt. Das jeweilige Kontaktsegment kann Teil einer der zuvor erläuterten Kontaktlaschen sein.

In einer Ausführungsform beträgt ein Induktivitätswert der Anordnung weniger als 15 nH (Nanohenry). Es hat sich in numerischen Simulationen gezeigt, dass aufgrund der parallelen Orientierung der Stromschienen in dem mindestens einen Abschnitt ein solcher Induktivitätswert erreicht werden kann. Hierdurch können besonders hohe Schaltgeschwindigkeiten in den Leistungshalbleitern erreicht werden. Insbesondere beträgt der Induktivitätswert der Anordnung weniger als 10 nH.

In einer Ausführungsform weist der mindestens eine Abschnitt eine Breite von mindestens 3 cm auf. Hierdurch ist eine parallele Orientierung der Stromschienen auch in einer weiteren Raumrichtung über die Breite von mindestens 3 cm gewährleistet. Die Breite des Abschnitts führt dazu, dass sich die im Betrieb einstellenden Magnetfelder besser in dem mindestens einen Abschnitt verteilen und eine magnetische Kopplung pro Flächeneinheit zwischen den Stromschienen reduziert ist, was wiederum zu einer Verringerung der Induktivität führt. Die Breite des Abschnitts kann parallel zu der Oberfläche zumindest einer Stromschiene orientiert sein. Die Breite des Abschnitts kann z.B. in der Raumrichtung orientiert sein, um welche die Stromschienen gekrümmt sind. Die Breite des Abschnitts kann insbesondere orthogonal zu einer Fließrichtung eines Stroms durch die jeweilige Stromschiene orientiert sein.

In einer weiteren Ausführungsform kann die mindestens eine Anordnung Teil mindestens einer ersten Komponente einer leistungselektronischen Vorrichtung sein und dauerhaft mit der mindestens einen ersten Komponente verbunden sein. Auf diese Weise können die zur Herstellung einer elektrischen Verbindung zwischen der ersten Komponente und einer weiteren Komponente der Vorrichtung nötigen Fügestellen reduziert werden. Die mindestens eine Anordnung kann mit der mindestens einen ersten Komponente z.B. bereits vor dem Einbau in der leistungselektronischen Vorrichtung dauerhaft verbunden worden sein. Hierdurch kann es ausreichen, beim Zusammenbau der Vorrichtung die Stromschienen mit z.B. Kontaktflächen der weiteren Komponente dauerhaft zu verbinden, um mittels der Anordnung eine dauerhafte elektrische Verbindung zwischen den Komponenten der leistungselektronischen Vorrichtung herzustellen.

Insbesondere macht die vorgeschlagene Anordnung die Verwendung von Verbindungsstücken - wie z.B. Schweißblechen - zwischen den Enden der Stromschienen der Anordnung und Kontaktflächen der zu verbindenden Komponenten unnötig, da aufgrund der beschriebenen Krümmung der Stromschienen Unterschiede in den Montagepositionen der Komponenten überbrückt werden können und somit eine unmittelbare Kontaktierung der Kontaktflächen der Komponenten mittels der Anordnung ohne zusätzliche Verbindungsstücke möglich ist.

Die Erfindung wird anhand von Ausführungsbeispielen näher erläutert. Die Figuren zeigen:
- Fig. 1: eine Querschnittsansicht einer Ausführungsform einer leistungselektronischen Vorrichtung mit einer Anordnung von Stromschienen und
- Fig. 2: eine perspektivische Ansicht einer Ausführungsform einer leistungselektronischen Vorrichtung mit einer Anordnung von Stromschienen.

Nachfolgend bezeichnen gleiche Bezugszeichen Elemente mit gleichen technischen Merkmalen.

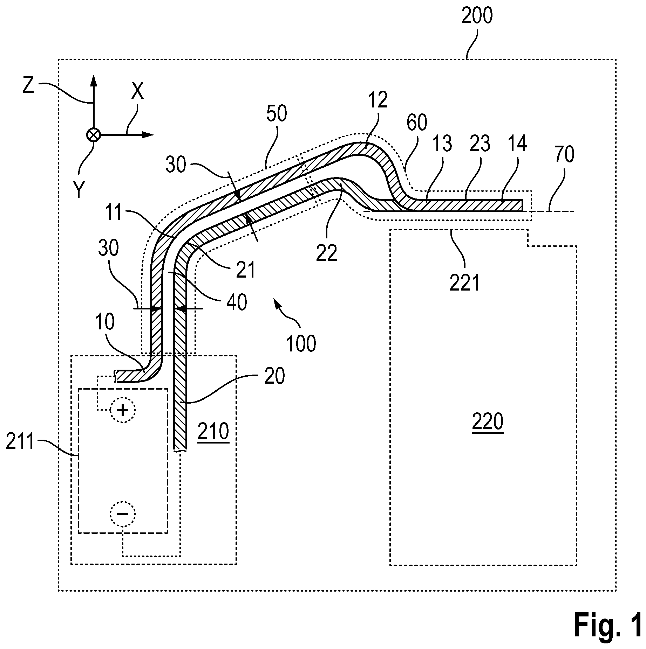

Fig. 1 zeigt eine Querschnittsansicht einer Ausführungsform einer leistungselektronischen Vorrichtung 200 mit einer Anordnung 100 von Stromschienen 10, 20, die abschnittsweise parallel zueinander orientiert sind.

Die als Wechselrichter ausgebildete leistungselektronische Vorrichtung 200 kann mehrere leistungselektronische Komponenten 210, 220 umfassen. Eine erste Komponente 210 ist z.B. als Zwischenkreiskondensator ausgebildet. Eine weitere Komponente 220 ist z.B. als Leistungsbox ausgebildet. Die erste Komponente 210 ist mit der weiteren Komponente 220 mittels der Anordnung 100 von Stromschienen 10, 20 elektrisch verbunden.

Innerhalb der Vorrichtung 200 kann eine Orientierung der Anordnung 100 durch ein raumfestes, kartesisches Koordinatensystem X, Y, Z beschrieben werden. Eine Hochachse Z des Koordinatensystems X, Y, Z kann entgegen der Richtung der Schwerkraft und parallel zu einer vertikalen Raumrichtung orientiert sein. Eine Längsachse X des Koordinatensystems X, Y, Z kann orthogonal zu der Hochachse Z und parallel zu einer ersten horizontalen Raumrichtung orientiert sein. Eine Querachse Y des Koordinatensystems X, Y, Z kann orthogonal zu der Längsachse X, orthogonal zu der Hochachse Z und parallel zu einer weiteren horizontalen Raumrichtung orientiert sein.

Die erste Komponente 210 weist ein als Speicherzelle ausgebildetes Energiespeicherelement 211 auf. Ein Anschlussdes Energiespeicherelements 211 (in Fig. 1 durch ein Pluszeichen gekennzeichnet, welches nicht zwingend eine Polarität des Energiespeicherelements 211 darstellt) ist mit einer ersten Stromschiene 10 der Anordnung 100 elektrisch verbunden. Die erste Stromschiene 10 kann ein positives bzw. hohes elektrisches Potential + aufweisen. Dies wird auch als erstes elektrisches Potential + bezeichnet. Ein weiterer Anschluss des Energiespeicherelements 211 (in Fig. 1 durch ein Minuszeichen gekennzeichnet, welches nicht zwingend eine Polarität des Energiespeicherelements 211 darstellt) ist mit einer weiteren Stromschiene 20 der Anordnung 100 elektrisch verbunden. Die weitere Stromschiene 20 kann ein negatives bzw. niedriges elektrisches Potential - aufweisen. Dies wird auch als weiteres elektrisches Potential bezeichnet. Alternativ kann die erste Stromschiene 10 ein niedrigeres Potential als die weitere Stromschiene 20 aufweisen. Die Anordnung 100 kann insbesondere bereits vor der Montage der Vorrichtung 200 in der ersten Komponente 210 angeordnet sein und mit dieser zusammen in die Vorrichtung 200 eingebaut werden. Dies verringert die Anzahl der Montageschritte.

In einem Abschnitt 50 (in Fig. 1 durch eine Strichlinienkontur umrandet) der Anordnung 100 verläuft die erste Stromschiene 10 parallel zu der weiteren Stromschiene 20. Aufgrund des parallelen Verlaufs der Stromschienen 10, 20 in dem Abschnitt 50 kann eine Induktivität der Anordnung 100 verringert werden, da ein Abstand 30 (durch Doppelpfeile gekennzeichnet) zwischen den Stromschienen 10, 20 sehr klein gehalten werden kann, wobei der geringe Abstand 30 wiederum maßgeblich für die niedrige Induktivität ist. Beispielsweise beträgt der Abstand 30 zwischen den Stromschienen 10, 20 in dem Abschnitt 50 weniger als 1 mm.

Ferner weist die erste Stromschiene 10 in dem Abschnitt 50 eine Krümmung 11 auf und die weitere Stromschiene 20 weist in dem Abschnitt 50 eine Krümmung 21 auf. Beide Krümmungen 11, 21 weisen Radien auf. Die Radien können aber auch gegen null gehen (d.h. die Stromschienen können derart gekrümmt sein, dass man die Krümmungen 11, 21 als Knicke bezeichnen könnte). Aufgrund der Krümmungen 11, 21 können die Stromschienen 10, 20 zuerst eine vertikale Wegstrecke entlang der Hochachse Z und dann eine horizontal-vertikale Wegstrecke entlang der Längsachse X und Hochachse Z überbrücken, ohne den Abstand 30 zueinander in dem Abschnitt 50 zu vergrößern. Die Krümmungen 11, 21 erleichtern zudem die Montage der Vorrichtung 200, da die Anordnung 100 beispielsweise Unterschiede zwischen einer Montageposition der ersten Komponente 210 und einer Montageposition der weiteren Komponente 220 überbrücken kann.

In dem Abschnitt 50 wird zwischen den beiden Stromschienen 10, 20 ein Zwischenraum 40 aufgespannt. In diesem Zwischenraum 40 kann eine nichtleitende Schicht (nicht dargestellt) zwischen der ersten Stromschiene 10 und der weiteren Stromschiene 20 angeordnet sein. Diese nichtleitende Schicht kann z.B. Kunststoff aufweisen und nichtmagnetisch ausgebildet sein. Die nichtleitende Schicht kann den Zwischenraum 40 ganz oder zumindest teilweise ausfüllen. Die nichtleidende Schicht kann z.B. als Folie oder Beschichtung einer oder beider Stromschienen 10, 20 ausgebildet sein.

In einem weiteren Abschnitt 60 (in Fig. 1 ebenfalls durch eine Strichlinienkontur umrandet) der Anordnung 100 weist jede der Stromschienen 10, 20 eine Kontaktlasche 12, 22 auf. Die Kontaktlaschen 12, 22 bilden jeweils Endstücke der Stromschienen 10, 20. Die Kontaktlaschen 12, 22 dienen zur Kontaktierung der weiteren Komponente 220. Die Kontaktlaschen 12, 22 sind um die Querachse Y gekrümmt ausgebildet, um eine Federwirkung zu erzielen. Aufgrund der Federwirkung können Montagetoleranzen zwischen den Komponenten 210, 220 und mechanische oder thermische Spannungen ausgeglichen werden. Die Kontaktlaschen 12, 22 sind in Fig. 1 sogar zweifach um die Querachse Y gekrümmt, um die Orientierung der jeweiligen freien Enden der Kontaktlaschen 12, 22 einer Orientierung einer zugehörigen Kontaktfläche 221 der weiteren Komponente 220 angleichen zu können.

Die Kontaktlaschen 12, 22 weisen jeweils Kontaktsegmente 13, 14, 23 auf, die die freien Enden der Kontaktlaschen 12, 22 bilden. Aufgrund der in Fig. 1 gezeigten Querschnittsansicht ist lediglich das Kontaktsegment 13 der Kontaktlasche 12 der ersten Stromschiene 10 sichtbar. Das Kontaktsegment 13 verdeckt ein weiteres Kontaktsegment 14 der ersten Stromschiene 10 und ein zu der weiteren Stromschiene 20 gehöhrendes Kontaktsegment 23 der weiteren Kontaktlasche 22. Die Kontaktsegmente 13, 14, 23 sind derart im Raum orientiert, dass die Unterseiten der Kontaktsegmente 13, 14, 23 eine gemeinsame Ebene 70 aufspannen, die parallel zu einer durch die Längsachse X und die Querachse Y aufgespannten Horizontalebene orientiert ist.

Über die Unterseite des Kontaktsegments 13 der ersten Stromschiene 10 kann die Kontaktfläche 221 der weiteren Komponente 220 kontaktiert werden. Die Kontaktfläche 221 kann z.B. eine Anschlussfläche eines Pluspols (nicht dargestellt) der weiteren Komponente 220 sein. Hierdurch kann mittels des Kontaktsegments 13 eine elektrische Verbindung zwischen dem Anschluss des Energiespeicherelements 211 der ersten Komponente 210 und dem Pluspol der weiteren Komponente 220 hergestellt werden. Insbesondere kann das Kontaktsegment 13 mit der Kontaktfläche 221 z.B. durch ein Fügeverfahren wie Schweißen dauerhaft verbunden werden (nicht dargestellt). Analoges gilt für das weitere Kontaktsegment 14 der ersten Stromschiene 10 (nicht dargestellt).

Über die Unterseite des durch das Kontaktsegment 13 verdeckten Kontaktsegments 23 der weiteren Stromschiene 20 kann eine zugehörige Kontaktfläche (nicht dargestellt) der weiteren Komponente 220 kontaktiert werden. Die zugehörige Kontaktfläche kann z.B. eine Anschlussfläche eines Minuspols (nicht dargestellt) der weiteren Komponente 220 sein. Hierdurch kann mittels des Kontaktsegments 23 eine elektrische Verbindung zwischen dem weiteren Anschluss des Energiespeicherelements 211 der ersten Komponente 210 und dem Minuspol der weiteren Komponente 220 hergestellt werden. Auch dieses Kontaktsegment 23 kann mit der zugehörigen Kontaktfläche z.B. durch ein Fügeverfahren wie Schweißen dauerhaft verbunden werden (nicht dargestellt).

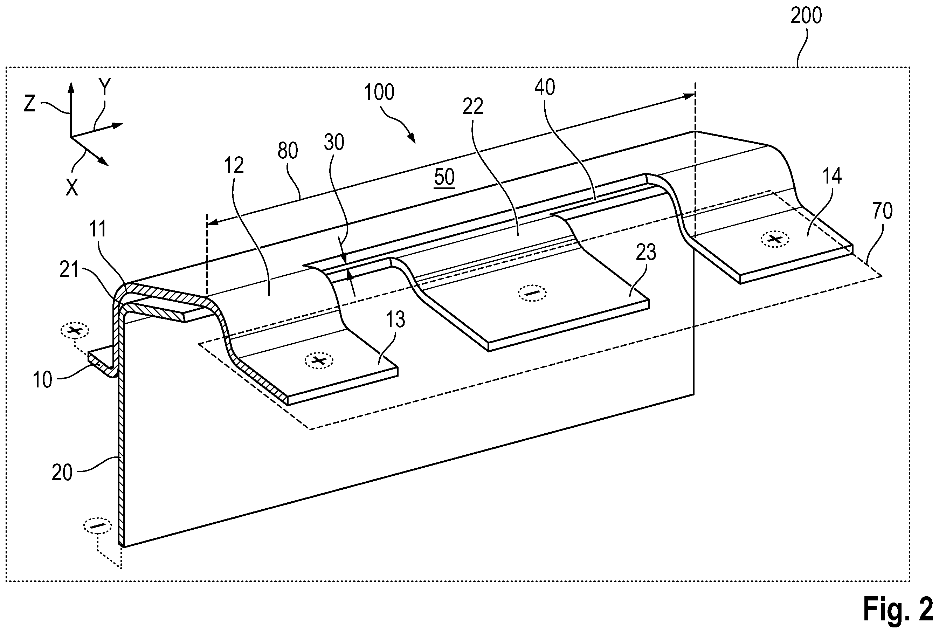

Fig. 2 zeigt eine perspektivische Ansicht einer Ausführungsform einer leistungselektronischen Vorrichtung 200 mit einer Anordnung 100. In Fig. 2 sind die Komponenten 210, 220 der Vorrichtung 200 nicht dargestellt, um zusätzliche Details der Anordnung 100 erkennbar zu machen, die in der in Fig. 1 gezeigten Querschnittsansicht nicht sichtbar sind.

So ist in Fig. 2 erkennbar, dass der Abschnitt 50 eine Breite 80 entlang der Querachse Y aufweist. In dem Abschnitt 50 sind die Stromschienen 10, 20 sowohl entlang der Hochachse Z als auch entlang der Längsachse X parallel zueinander orientiert - wie bereits zu Fig. 1 erläutert. In dieser dritten Raumrichtung entlang der Querachse Y sind die Stromschienen 10, 20 über die Breite 80 parallel zueinander orientiert. Die Breite 80 kann z.B. bestimmt werden, indem eine geometrischen Projektion der ersten Stromschiene 10 entlang der Längsachse X auf die weitere Stromschiene 20 erfolgt, wobei die Projektion ganz oder teilweise auf eine Oberfläche der weiteren Stromschiene 20 fällt. Die Breite 80 entspricht dann z.B. der Abmessung des Anteils dieser geometrischen Projektion entlang der Querachse Y, der auf die Oberfläche der weiteren Stromschiene 20 fällt. Insbesondere beträgt die Breite 80 des Abschnitts 50 mindestens 3 cm.

Ferner ist in Fig. 2 erkennbar, dass die erste Stromschiene 10, welche ein positives elektrisches Potential "+" aufweist (in Fig. 2 durch Pluszeichen gekennzeichnet), in zwei Kontaktsegmente 13, 14 mündet. Die weitere Stromschiene 20, welche ein negatives elektrisches Potential "-" aufweist (in Fig. 2 durch Minuszeichen gekennzeichnet), mündet in ein Kontaktsegment 23. Die Unterseiten der Kontaktsegmente 13, 14, 23 spannen eine gemeinsame Ebene 70 auf und dienen zur Kontaktierung der weiteren Komponente 210 (nicht dargestellt).

Abschließend sei noch erwähnt, dass aus Fig. 2 ersichtlich wird, dass die Stromschienen 10, 20 unterschiedliche Abmessungen aufweisen können, die z.B. konstruktionsbedingt sind und an einen verfügbaren Bauraum angepasst sind. Im Rahmen dieser konstruktiven Bedingung bietet die Anordnung 100 jedoch eine maximierte Überlappung in dem Abschnitt 50 - d.h. eine maximale parallele Orientierung der Stromschienen 10, 20. Gleichzeitig ist der Abstand 30 in dem Abschnitt 50 minimal. Auf diese Weise kann die Induktivität so niedrig wie möglich gehalten werden. Beispielsweise kann ein Induktivitätswert der gezeigten Anordnung 100 weniger als 15 Nanohenry betragen.

### Bezugszeichenliste

- 10: erste Stromschiene
- 11: Krümmung der ersten Stromschiene
- 12: Kontaktlasche der ersten Stromschiene
- 13: Kontaktsegment der ersten Stromschiene
- 14: weiteres Kontaktsegment der ersten Stromschiene
- 20: weitere Stromschiene
- 21: Krümmung der weiteren Stromschiene
- 22: Kontaktlasche der weiteren Stromschiene
- 23: Kontaktsegment der weiteren Stromschiene
- 30: Abstand
- 40: Zwischenraum
- 50: Abschnitt der Anordnung
- 60: weiterer Abschnitt der Anordnung
- 70: Ebene
- 80: Breite
- 100: Anordnung
- 200: Vorrichtung
- 210: erste Komponente
- 211: Energiespeicherelement
- 220: weitere Komponente
- 221: Kontaktfläche der weiteren Komponenten
- X: Längsachse
- Y: Querachse
- Z: Hochachse
- +: positives elektrisches Potential
- -: negatives elektrisches Potential

## Patentansprüche

1. Leistungselektronische Anordnung (100) von Stromschienen (10, 20), umfassend mindestens eine erste Stromschiene (10) eines ersten elektrischen Potentials (+) und mindestens eine weitere Stromschiene (20) eines weiteren elektrischen Potentials (-), wobei die Stromschienen (10, 20) zueinander beabstandet sind, wobei in mindestens einem Abschnitt (50) der Anordnung (100) die mindestens eine erste Stromschiene (10) parallel zu der mindestens einen weiteren Stromschiene (20) orientiert ist, wobei sowohl die mindestens eine erste Stromschiene (10) als auch die mindestens eine weitere Stromschiene (20) in dem mindestens einen Abschnitt (50) gekrümmt (11, 21) ausgebildet sind.

2. Anordnung (100) nach Anspruch 1, **dadurch gekennzeichnet, dass** ein Abstand (30) zwischen der mindestens einen ersten Stromschiene (10) und der mindestens einen weiteren Stromschiene (20) in dem mindestens einen Abschnitt (50) weniger als 1 mm beträgt.

3. Anordnung (100) nach einem der vorangegangenen Ansprüche, **dadurch gekennzeichnet, dass** in dem mindestens einen Abschnitt (50) eine nichtleitende Schicht zwischen der mindestens einen ersten Stromschiene (10) und der mindestens einen weiteren Stromschiene (20) angeordnet ist.

4. Anordnung (100) nach einem der vorangegangenen Ansprüche, **dadurch gekennzeichnet, dass** zumindest eine der Stromschienen (10, 20) mindestens eine Kontaktlasche (12, 22) umfasst, wobei die mindestens eine Kontaktlasche (12, 22) eine Federwirkung aufweist.

5. Anordnung (100) nach Anspruch 4, **dadurch gekennzeichnet, dass** die mindestens eine Kontaktlasche (12, 22) gekrümmt ausgebildet ist.

6. Anordnung (100) nach einem der vorangegangenen Ansprüche, **dadurch gekennzeichnet, dass** die mindestens eine erste Stromschiene (10) und die mindestens eine weitere Stromschiene (20) jeweils mindestens ein Kontaktsegment (13, 14, 23) aufweisen, wobei die Kontaktsegmente (13, 14, 23) in einer gemeinsamen Ebene (70) angeordnet sind.

7. Anordnung (100) nach einem der vorangegangenen Ansprüche, **dadurch gekennzeichnet, dass** ein Induktivitätswert der Anordnung (100) weniger als 15 nH (Nanohenry) beträgt.

8. Anordnung (100) nach einem der vorangegangenen Ansprüche, **dadurch gekennzeichnet, dass** der mindestens eine Abschnitt (50) eine Breite (80) von mindestens 3 cm aufweist.

9. Leistungselektronische Komponente (210, 220), umfassend mindestens eine leistungselektronische Anordnung (100) nach einem der Ansprüche 1 bis 8.

10. Leistungselektronische Vorrichtung (200), umfassend mindestens eine erste Komponente (210) und mindestens eine weitere Komponente (220), wobei die mindestens eine erste Komponente (210) mit der mindestens einen weiteren Komponente (220) mittels mindestens einer leistungselektronischen Anordnung (100) nach einem der Ansprüche 1 bis 8 elektrisch verbunden ist.
